# DEMANDE DE BREVET EUROPEEN

(11) **EP 0 875 922 A1**
(43) Date de publication de la demande: **04.11.1998**
(21) Numéro de dépôt: 98400784.9
(22) Date de dépôt: 02.04.1998
(51) Int. Cl.: H01L 21/20, H01L 27/15

(54) **Technologie sans gravure pour intégration de composants**

(30) Priorité: 03.04.1997 FR 9704070
(71) Demandeur: FRANCE TELECOM, 75015 Paris (FR)
(72) Inventeur: Jahan, Denis, 92700 Colombes (FR); Legay, Philippe, 92120 Montrouge (FR)
(74) Mandataire: Texier, Christian

(57) **Abrégé**

L'invention concerne un procédé d'intégration de plusieurs structures à semi-conducteur sur un substrat, selon lequel on réalise :
- un dépôt d'un masque primaire sur ledit substrat (2),
- des ouvertures dans ce masque découvrant des zones choisies de la surface du substrat (2),
- une épitaxie d'une structure A de composant semi-conducteur localisée dans ces zones, terminée par
- une épitaxie d'un matériau B (15) localisée sur la structure A (10), le matériau B (15) étant apte à être transformé sélectivement en un matériau C pouvant constituer un masque (15) pour épitaxie localisée,
- un retrait dudit masque primaire,
- une transformation sélective dudit matériau B en ledit matériau C de sorte que le matériau C constitue un autre masque (15) pour épitaxie localisée, et
- une épitaxie d'une structure D (20) de composant semi-conducteur localisée à l'extérieur dudit autre masque.

## Description

La présente invention concerne le domaine des semi-conducteurs.

Plus précisément, l'invention concerne l'intégration monolithique, c'est-à-dire l'intégration sur un même substrat, de différentes structures de semi-conducteurs correspondant à des composants différents.

Cette intégration concerne les domaines de l'optoélectronique dans le cas par exemple d'une intégration laser/modulateur, de la micro-électronique dans le cas par exemple d'une réalisation de circuits intégrés, ou ces deux domaines ensemble dans le cas par exemple de l'intégration d'un laser avec son circuit de commande.

Plusieurs techniques d'intégration existent actuellement.

L'épitaxie par organométallique sélective (EPVOM) ne nécessite qu'une seule étape d'épitaxie : son principe repose sur le fait qu'il est possible de faire varier la composition et l'épaisseur d'un alliage quaternaire GaₓIn₁₋ₓAs_{y}P_{1-y} sur une surface donnée en la limitant par un masque diélectrique de géométrie appropriée. On peut ainsi épitaxier bout à bout deux quaternaires de longueurs d'onde d'émission différentes avec une interface graduelle entre les deux. Cette technique a été appliquée à l'intégration laser-modulateur [1].

L'inconvénient majeur de cette technique est que seuls deux composants de structure très proche peuvent être intégrés. Pour un premier composant donné, le choix du deuxième composant à intégrer est restreint. D'autre part, cette technique s'avère inadaptée pour l'épitaxie de structures épaisses (supérieures à 1 micron).

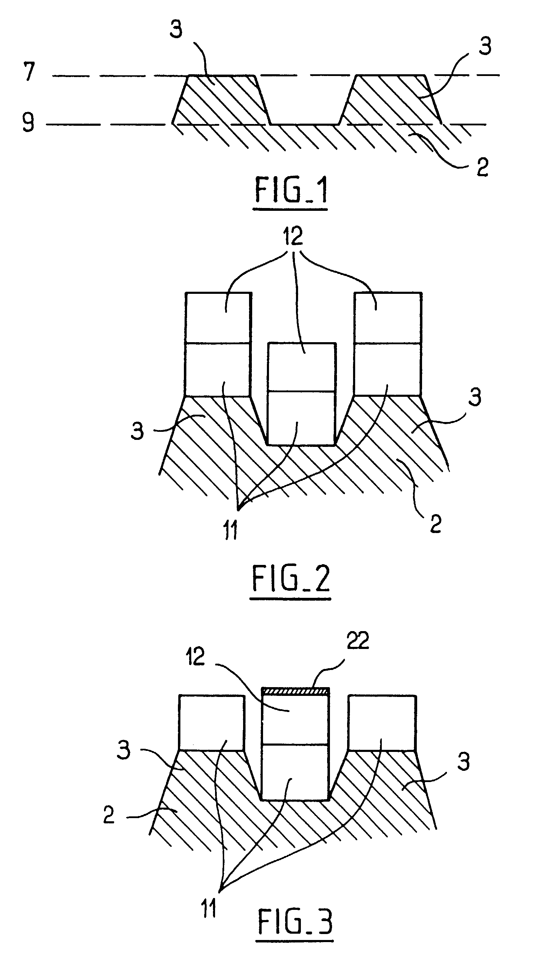

Une seconde méthode connue, la croissance sur substrat gravé, comprend trois étapes technologiques que l'on a représentées aux figures 1 à 3.

La première étape consiste à graver partiellement un substrat 2 afin de réaliser un niveau haut 7 et un niveau bas 9 à la surface du substrat 2.

La deuxième étape consiste à épitaxier deux composants 11 et 12 successivement sur la structure d'ensemble. Etant donné la différence de niveau initiale due à la gravure, on arrive à ajuster les deux composants côte-à-côte sur le niveau haut (en réalisant pour cela une gravure entre les deux niveaux 7 et 9 de profondeur égale à l'épaisseur du premier composant 11).

La troisième étape consiste à planariser la structure finale en gravant uniquement la structure du deuxième composant épitaxié 12, dans les régions correspondant au niveau haut 7 du substrat 2. Pour cela, on protège la structure du deuxième composant épitaxié 12 dans les régions correspondant au niveau bas 9 du substrat 2 par un masque 22 de protection contre les gravures.

Cette technique a notamment été utilisée avec succès pour l'intégration d'un photodétecteur et d'un transistor à effet de champ [2].

Toutefois, la troisième étape de gravure (planarisante) s'avère délicate lorsque les dimensions des composants diminuent. Il peut de plus y avoir croissance, aux limites entre niveau haut 7 et niveau bas 9, que ce soit sur les flancs de mésas 3 ou sur les flancs des composants 11 et 12, ce qui fait apparaître des ponts entre les deux niveaux.

Un inconvénient majeur de cette technique réside dans le fait qu'il est difficile d'épitaxier des composants parfaitement fonctionnels sur des surfaces préalablement gravées. En effet, les gravures engendrent des défauts cristallographiques et des contaminations d'interface.

Une troisième technique connue est la reprise d'épitaxie localisée.

Dans cette technique, la structure du premier composant est d'abord épitaxiée pleine plaque sur un substrat plan.

Un masque de diélectrique, généralement SiNx ou SiO₂ est ensuite déposé, puis gravé en certains endroits.

Les parties de la structure du premier composant non protégées par le masque sont alors gravées. Un traitement de surface appelé régénération de surface, est ensuite réalisé sur la surface gravée pour minimiser au maximum les effets des défauts engendrés par la gravure.

Une reprise d'épitaxie localisée de la structure du second composant est ensuite effectuée sur les zones du semi-conducteur ainsi découvertes.

Cette technique est basée sur le fait que sous certaines conditions de température et de flux d'éléments III et V, il est possible de faire croître sélectivement, de façon monocristalline, un semi-conducteur sur un autre semi-conducteur tout en empêchant la croissance sur des surfaces d'une autre nature (diélectrique par exemple).

Dans ce cas, il n'y a aucun dépôt sur le masque [3]. L'épitaxie par jets chimiques (EJC ou CBE) et l'épitaxie en phase vapeur aux organométalliques (EPVOM) permettent de réaliser ces épitaxies localisées. On obtient ainsi, l'une à côté de l'autre, deux structures de composants différents. Les interfaces latérales entre les deux composants peuvent être de bonne qualité.

Cette dernière propriété est nécessaire pour intégrer deux composants photoniques et permettre, entre autre, le passage de la lumière avec de faibles pertes. Elle est réalisée avec un auto-alignement parfait et une interface jointive de qualité entre les deux structures épitaxiées. L'auto-alignement permet aussi d'améliorer les performances de certains composants microélectroniques.

La reprise d'épitaxie localisée est une technique planarisante, c'est-à-dire que tous les composants en fin de réalisation peuvent être situés sur une même niveau. La planéité assure de bonnes caractéristiques mécaniques aux futures interconnexions et favorise des étapes de lithographie plus fines en dimension.

L'inconvénient de cette technique est là encore inhérent à la gravure. En effet, la reprise d'épitaxie est effectuée sur une surface de substrat préalablement gravée et donc perturbée. La régénération de la surface, effectuée juste avant l'épitaxie localisée, n'est pas suffisante pour éliminer les défauts et la contamination.

De manière générale, les performances des composants épitaxiés sur substrat gravé sont dégradées.

Deux exemples illustrent ceci :

Les pertes optiques dans des guides d'ondes épitaxiés sur surfaces gravées sont beaucoup plus importantes que celles observées dans des guides épitaxiés sur des substrats plans non gravés. Les défauts cristallins et la rugosité sont dans ce cas en cause.

La contamination des surfaces gravées, constituée essentiellement de C et de Si, peut être électriquement active et peut ainsi modifier les propriétés électriques des composants épitaxiés localement sur ces surfaces.

On connaît, par ailleurs, les travaux de J.P. Dallesasse sur l'oxydation sélective des alliages contenant de l'aluminium [4]. Ils ont montré que ces oxydes ont des propriétés électriques et mécaniques intéressantes.

Ils sont notamment très utiles pour la réalisation de couches de confinement électriques et optiques, notamment dans les lasers à cavité verticale. Ces couches sont obtenues par l'oxydation partielle d'un alliage AlₓGa₁₋ₓAs.

On connaît une seconde application de ces oxydes, elle aussi dans la réalisation de miroirs de Bragg.

On cherche, dans un miroir de Bragg, à empiler, par épitaxies successives, des couches de matériaux d'indices de réfraction qui soient différents d'une couche à l'autre, de manière à obtenir de fortes différences d'indices au travers des couches.

Or, les différences d'indices de réfraction entre les couches de semi-conducteurs que l'on peut obtenir sont faibles, ce qui oblige habituellement à multiplier le nombre de couches des miroirs de Bragg.

On met à profit, dans cette seconde application, la différence de valeur de l'indice de réfraction de l'alliage et de son oxyde.

On intercale des couches de semi-conducteurs d'alliage contenant de l'aluminium avec des couches de semi-conducteurs d'indice de réfraction assez proche de celui de l'alliage. Les alliages contenant de l'aluminium sont ensuite oxydés sélectivement, formant ainsi des couches dont l'indice de réfraction est éloigné de ceux des couches de semi-conducteurs adjacentes. L'oxydation sélective des alliages à forte teneur en aluminium permet ainsi de réaliser des empilements de couches de matériaux avec de forts écarts d'indices de réfraction entre les couches et ainsi de réaliser des miroirs de Bragg ayant un nombre de couches particulièrement faible.

Le but de la présente invention est de permettre d'intégrer sur un même substrat au moins deux structures de matériaux semi-conducteurs pouvant être très différents, les deux structures étant épitaxiées sur des zones du substrat non perturbées par exemple par une gravure préalable. Cette première caractéristique permet d'obtenir des structures de qualité cristallographique excellente.

Un autre but est de proposer un procédé qui permette également une intégration plane.

Un autre but est de proposer un procédé qui permette d'obtenir des interfaces jointives de qualité entre deux structures epitaxiées.

Un autre but de l'invention est de proposer un procédé permettant également un auto-alignement des structures parfait et aisément mis en oeuvre.

Ces buts sont atteints selon la présente invention grâce à un procédé d'intégration de plusieurs structures à semi-conducteur sur un même substrat, selon lequel on réalise :
a) un dépôt d'un masque primaire sur ledit substrat,
b) des ouvertures dans ce masque primaire découvrant des zones choisies de la surface du substrat,
c) une épitaxie d'une structure A de composant semi-conducteur localisée dans lesdites zones choisies du substrat, terminée par
d) une épitaxie d'un matériau B localisée sur la structure A, le matériau B étant apte à être transformé sélectivement en un matériau C pouvant constituer un masque pour épitaxie localisée,
e) un retrait dudit masque primaire,
f) une transformation sélective dudit matériau B en ledit matériau C de sorte que le matériau C constitue un autre masque pour épitaxie localisée, et
g) une épitaxie d'une structure D de composant semi-conducteur localisée à l'extérieur dudit autre masque.

D'autres caractéristiques, buts et avantages de la présente invention apparaîtront à la lecture de la description détaillée qui va suivre, et en regard des dessins annexés, donnés à titre d'exemple non limitatif et sur lesquels :
- la figure 1 précédemment décrite est une vue en coupe d'un substrat gravé, selon un plan de coupe perpendiculaire à la surface du substrat selon une technique classique ;
- la figure 2 précédemment décrite est une même vue du même substrat gravé sur lequel deux composants ont été épitaxiés successivement sur le substrat entier selon une technique classique ;
- la figure 3 est une même vue du même ensemble dans laquelle la structure classique finale a été planarisée ;
- la figure 4 est une vue en coupe d'un substrat recouvert d'un masque, selon un plan de coupe perpendiculaire à la surface du substrat, conforme à la présente invention;
- la figure 5 est une vue en coupe du même ensemble, dans lequel le masque a été gravé dans une zone choisie, conforme à la présente invention ;
- la figure 6 est une même vue en coupe du même ensemble comportant en outre une première structure de semi- conducteur épitaxiée et une couche d'alliage à forte teneur en aluminium déposée par épitaxie sur cette première structure, conforme à la présente invention ;
- la figure 7 est une même vue du même ensemble, dans laquelle le masque a été retiré conformément à la présente invention ;
- la figure 8 est une même vue en coupe du même ensemble dans lequel l'alliage à forte teneur en aluminium a été oxydé conformément à la présente invention ;
- la figure 9 est une même vue du même ensemble dans lequel une seconde structure de matériau semi-conducteur conforme à la présente invention a été déposée par épitaxie sur le substrat, aux endroits non protégés par l'alliage oxydé ;
- la figure 10 est une même vue du même ensemble dans lequel l'alliage oxydé a été enlevé conformément à la présente invention ;
- la figure 11 est une vue sous forme de blocs fonctionnels d'un dispositif de traitement de structures de semi-conducteurs permettant de réaliser une oxydation sélective d'une couche d'alliage à forte teneur en aluminium, conforme à la présente invention ; et
- les figures 12A à 12K sont des vues en coupe selon un même plan de coupe perpendiculaire à la surface d'un substrat, d'étapes d'une intégration monolithique conforme à une variante de l'invention, où trois structures à semi-conducteur sont intégrées sur un même substrat.

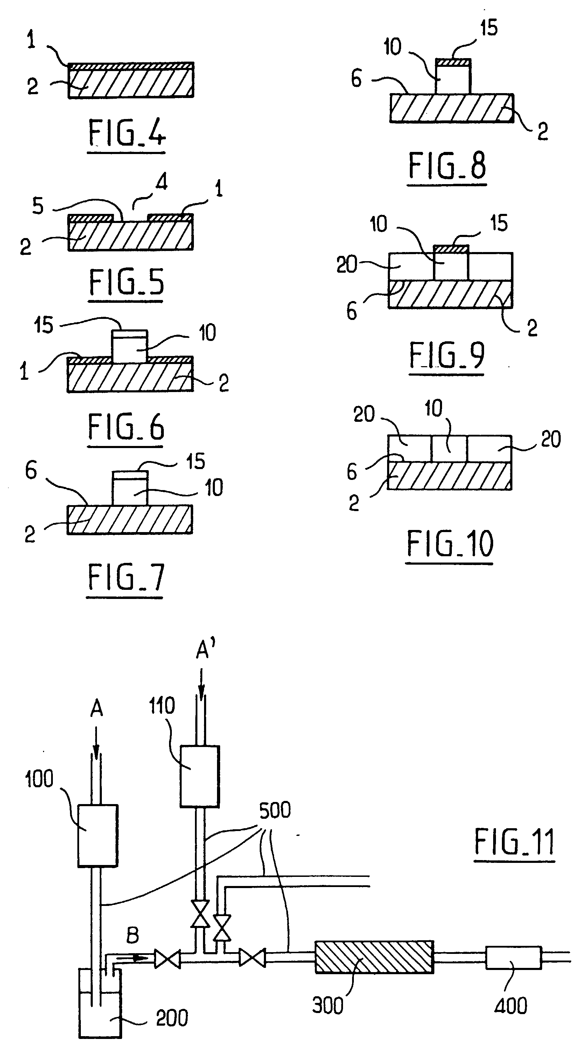

On a représenté, sur les figures 4 à 10, différentes étapes technologiques consécutives d'un procédé d'intégration monolithique selon l'invention.

On décrira maintenant ces différentes étapes.

On a représenté à la figure 4 un substrat plan 2. Ce substrat est de type non gravé, préparé par le fournisseur pour être prêt à l'emploi. Ce type de substrat est appelé communément substrat "épi-ready". A la surface de ce substrat 2 a été déposé un masque 1 de nitrure. En variante, le masque 1 peut être réalisé avec tout matériau apte à constituer un masque pour épitaxie localisée, tel que SiO₂. Ces masques ont la propriété de présenter une surface extérieure peu réactive vis-à-vis des espèces incidentes, en partie grâce au fait que ces masques sont amorphes et possèdent une faible densité de liaisons pendantes.

Le dépôt du masque de nitrure 1 sur le substrat 2 est effectué par la technique CVD (Chemical Vapor Deposition) assistée par plasma à partir du silane et de l'azote.

Dans un deuxième temps, on définit sur le masque primaire 1 des motifs par un procédé de lithographie classique : une résine photosensible protège le nitrure aux endroits où il doit rester, tandis que les parties exposées du nitrure sont gravées par Gravure Ionique Réactive (RIE).

De manière connue, on sait réaliser la gravure de façon à ne pas altérer la surface du substrat 2.

En effet, l'homme de l'art sait réaliser des gravures, qu'elles soient des gravures ioniques réactives ou des gravures chimiques, qui ne réagissent qu'avec un tel masque de nitrure et ne réagissent pas avec un matériau semi-conducteur.

On réalise donc une ouverture 4 dans le masque de nitrure 1, découvrant une surface 5 de substrat aucunement altérée, qui constitue ainsi une surface propice à la croissance localisée par épitaxie, ayant gardé ses qualités de surface initiales, c'est-à-dire avant le dépôt du masque de nitrure 1. L'ensemble constitué par le substrat 2 et le masque 1 gravé est représenté à la figure 5.

Comme représenté à la figure 6, on réalise dans un troisième temps, une croissance par épitaxie localisée d'une première structure 10 de composant semi-conducteur A.

L'épitaxie localisée de la structure 10 est réalisée par une technique connue d'épitaxie par jets chimiques. On trouvera de nombreuses précisions sur cette technique dans [3].

La croissance localisée est un cas particulier de croissance sélective où la croissance est confinée spatialement. Le composant A épitaxié est ici réalisé à partir de matériaux semi-conducteurs III-V tel que GaAs ou InP.

L'ouverture 4 faite dans le masque 1 expose des zones choisies 5 du substrat semi-conducteur 2 aux flux d'éléments III et V.

On observe alors une croissance monocristalline sur la zone exposée 5 du substrat, tandis qu'il n'y a aucun dépôt sur le masque diélectrique 1.

L'épitaxie localisée par jets chimiques permet, comme représenté sur la figure 6, que la croissance monocristaline 10 obtenue présente des flancs verticaux.

Plus précisément, de tels flancs verticaux sont facilement obtenus grâce à une épitaxie par jets chimiques réalisée sous des conditions de croissance optimisées. On trouvera de telles conditions de croissance optimisées dans le document [3], et dans le document [5].

L'invention ne se limite pas à l'utilisation d'une telle technique épitaxique mais prévoit également que toute autre technique de dépôt, notamment une technique permettant d'obtenir une structure 10 à flancs verticaux, soit adoptée.

Une quatrième étape consiste à ajouter, également par épitaxie localisée, une couche supplémentaire 15 d'un alliage à forte teneur en aluminium sur la surface supérieure de la structure 10.

Plus précisément, l'alliage constituant la couche 15 est préférentiellement un alliage dont la concentration en aluminium est supérieure à 80%.

L'homme de l'art entend par concentration en aluminium, la proportion en nombre d'atomes d'aluminium par rapport au nombre total d'atomes d'éléments III contenus dans l'alliage.

L'alliage utilisé dans l'exemple décrit ici est un alliage de formule AlₓGa₁₋ₓAs où x est supérieur à 0,80.

Dans le cas d'un tel alliage de formule AlₓGa₁₋ₓAs, la concentration en aluminium est donnée par le paramètre x. Il y a ainsi une concentration de 100 % d'As parmi les éléments V, une concentration de 80 % d'aluminium parmi les éléments III, et une concentration de 20 % de Ga parmi les éléments III.

L'épitaxie localisée de l'alliage a lieu en fin de croissance de la structure 10. La structure 10 et la couche 15 sont donc déposées l'une après l'autre en une même opération d'épitaxie localisée.

L'alliage constitutif de la couche 15 peut également être choisi parmi AlAs, Alₓln₁₋ₓAs, ou AlAs_{y}Sb_{1-y}.

L'alliage est éventuellement en désaccord de maille avec le matériau semi-conducteur A.

Cette couche 15 servira ultérieurement, et après un traitement apte à changer ses propriétés, de masque pour épitaxie localisée.

La couche 15 d'alliage ainsi déposée a la propriété d'être parfaitement alignée sur la surface de la première structure 10.

Il n'y a pas nécessité ici d'une étape de lithographie visant à aligner les bords de la couche 15 sur les bords de la structure 10, comme c'est le cas dans le cadre d'un dépôt de masque classique. Cette lithographie serait d'ailleurs difficilement praticable pour des faibles dimensions, inférieures à un micron.

La couche supplémentaire 15 déposée en fin de croissance de la première structure épitaxiée 10 a une épaisseur comprise entre 10 et 150 nanomètres.

Le masque de nitrure 1 est ensuite retiré par gravure chimique, en veillant à ne pas altérer les matériaux autres que le nitrure.

On utilise donc, à cette étape du procédé, une première propriété d'un alliage contenant de l'aluminium : un tel alliage, lorsqu'il n'est pas oxydé, résiste à une gravure chimique qui ne soit pas destinée à réagir avec un semi-conducteur, par exemple une gravure consistant à tremper une structure dans un bain de fluorure d'hydrogène.

Cette première propriété est mise à profit à cette étape de retrait par gravure chimique du masque primaire 1, par le fait que la couche d'alliage reste inaltérée et parfaitement alignée sur la structure 10 pendant l'attaque chimique du masque primaire.

Les inventeurs ont mis à profit une telle propriété d'inaltérabilité à la gravure chimique, en déposant cet alliage destiné à devenir un masque, avant le retrait du masque primaire 1.

On dépose ainsi, par épitaxie sélective, et donc avec un alignement parfait, une couche à transformer en masque, cette couche 15 restant en place malgré l'attaque chimique de retrait du masque 1.

On réalise donc, grâce à cette succession d'étapes, un retrait selectif d'un premier masque 1 sans enlever un second masque 15.

L'étape suivante consiste à réaliser une oxydation sélective de l'alliage riche en aluminium. Le procédé d'oxydation sélective utilisé pour cela fait intervenir un recuit autour de 400°C sous flux d'azote saturée en eau.

Ce procédé résulte des travaux de Dallesasse et al. sur l'oxydation des alliages AlₓGa₁₋ₓAs [4].

La figure 11 présente un dispositif appelé banc d'oxydation, permettant de réaliser cette oxydation sélective.

Un débit d'azote A, régulé par un débitmètre massique 100, est envoyé dans un bulleur 200 rempli d'eau et porté à une température voisine de 80°C. A la sortie du bulleur 200, le flux d'azote B, saturé en eau, est dirigé vers un four 300 dans lequel se trouve la structure constituée du substrat 2, de la structure 10 et de la couche d'alliage 15.

Le four 300 est porté à une température fluctuant entre 300 et 540°C suivant le matériau à oxyder.Idéalement, la température d'oxydation est choisie entre 350 et 400°C.

Le temps d'oxydation est variable. Il dépend du matériau à oxyder, de son épaisseur et de la température. A la sortie du four 300, la vapeur d'eau contenue dans l'azote est condensée par un condenseur 400 afin de contrôler la reproductibilité de l'expérimentation.

Il est possible d'ajouter un flux A' supplémentaire d'azote à la sortie du bulleur 200 afin de diminuer la pression de vapeur d'eau dans la ligne et ainsi d'éviter la condensation. Le flux d'azote est alors régulé par un débitmètre 110, comme représenté à la figure 11.

On note aussi que les lignes 500, qui relient le débitmètre 100 au bulleur 200, le bulleur 200 au four 300, le débitmètre 110 au four 300 et le four 300 au condensateur 400, sont chauffées autour de 60°C.

De cette manière, il est possible d'obtenir une très forte sélectivité d'oxydation entre les matériaux contenant peu ou pas du tout d'aluminium et ceux qui en contiennent beaucoup. A titre d'exemple, on peut dire que l'AlAs_{y}Sb_{1-y} s'oxyde notablement à partir de 300°C, l'AlAs à partir de 350°C, l'Al_{0,48}In_{0,52}As, qui est un alliage accordé en maille sur une structure d'InP, à partir de 500°C, et l'InP à partir de 5000C également.

L'alliage 15 est donc transformé en un oxyde sans que le matériau constitutif du substrat 2 ni la structure de composant semi-conducteur 10 ne subissent de transformation notable.

Une telle selectivité de l'oxydation, c'est à dire le fait que la couche d'alliage 15 soit oxydée sans que les couches sur lesquelles elle est posée ni le substrat soient oxydés, est particulièrement importante pour les étapes qui seront décrites ultérieurement.

Les inventeurs ont découvert que pour atteindre une sélectivité satisfaisante, on utilise avantageusement comme matériau constitutif de la couche 15 un alliage à forte teneur en aluminium. Plus précisément, on utilise avantageusement un alliage ayant une concentration en aluminium supérieure à 80%.

L'oxyde obtenu par le procédé d'oxydation décrit précédemment est isolant, amorphe et stable mécaniquement à la différence de ceux qui se forment à l'air ambiant.

Il est, de plus, apte à constituer un masque pour la diffusion, comme l'a montré J.P. Dallesasse [4].

Les inventeurs ont constaté que cet oxyde présente les caractéristiques nécessaires pour constituer un masque pour épitaxie localisée.

On obtient donc, après oxydation de la couche 15 une structure 10 recouverte par un masque 15 pour épitaxie localisée qui est parfaitement aligné sur la structure 10, le substrat 2 qui entoure la structure 10 ne présentant aucune altération dûe à une éventuelle gravure propre à réagir sur un semi-conducteur, ni aucune altération dûe à une éventuelle oxydation.

Cette aptitude de la couche 15 oxydée à constituer un masque pour épitaxie localisée est mise à profit lors d'une nouvelle étape d'épitaxie localisée.

Cette deuxième épitaxie donne lieu à une croissance localisée sur la zone 6 du substrat 2 précédemment masquée par le masque de nitrure 1. Cette zone 6 est complémentaire de la zone 5 du substrat découverte précédemment à l'étape de gravure du masque du nitrure 1.

On comprend que cette épitaxie localisée a lieu, comme celle de la première structure épitaxiée 10, sur une surface de substrat qui n'a pas subi de gravure ni de dégradation par oxydation et qui est donc de bonne qualité.

L'oxyde recouvre parfaitement la surface de la première structure épitaxiée 10, de sorte que l'on obtient un auto-alignement parfait entre la première structure épitaxiée 10 et la seconde structure épitaxiée 20. On obtient également une interface jointive de qualité, qualifiable de jonction parfaite, entre les flancs des structures 10 et 20.

Ces deux propriétés sont particulièrement importantes pour des applications de couplage optique. Pour obtenir cet autoalignement parfait et cette interface jointive, il est préférable que les flancs de la structure 10 soient verticaux.

En effet, si l'on épitaxie une seconde structure en bordure d'une première structure à flancs non verticaux, comme par exemple une première structure obtenue par une technique d'épitaxie localisée en phase vapeur et aux organométalliques sélective (MOCVD ou EPVOM), la première et la seconde structure ne se rejoindront pas directement par des couches actives, mais il apparaîtra une zone très perturbée entre les deux structures.

En effet, lors de la seconde épitaxie localisée, il y a dans ce cas deux fronts de croissance : l'un sur la surface du substrat, l'autre sur les côtés non verticaux de la première structure.

L'épitaxie localisée MOCVD fait de plus apparaître des surcroissances sur les flancs non verticaux de sorte qu'il est difficile d'obtenir une planarité de l'ensemble.

Si une telle zone perturbée n'est pas gênante lorsque l'on souhaite entourer la première structure par une simple couche de constriction, cette zone perturbée n'est pas tolérable dans le cas de structures multi-couches de composants.

Il est important que l'oxydation de la couche 15 d'alliage soit sélective. En effet, si l'oxydation n'est pas sélective, il se produit une oxydation non négligeable du substrat 2 et/ou de la structure 10, que la structure 10 ou le substrat 2 soient par exemple de l'InP ou du GaAs.

Dans un tel cas, il reste généralement des morceaux d'oxyde résiduels, par exemple d'oxyde du substrat 2.

En effet, l'oxyde de GaAs ou d'InP, lorsqu'il est trop important, ne desorbe pas ou désorbe partiellement lors d'un éventuel recuit préepitaxial. Il en résulte qu'il peut être rendu impossible d'épitaxier la seconde structure, et plus généralement, lorsque des résidus d'oxyde du substrat sont présents, on obtient une seconde structure épitaxiée de qualité cristallographique médiocre.

Si la qualité de la seconde structure n'est pas primordiale lorsque cette seconde structure est une couche de constriction, de tels défauts ne sont pas tolérables dans le cas de structures de composants.

Ainsi, si l'oxydation n'est pas sélective, on obtient généralement une seconde structure dont la qualité n'est pas meilleure que celle qui serait obtenue sur un substrat ou une structure préalablement gravée.

De plus, l'auto-alignement évoqué précédemment est permis par le fait que la structure 10 présente des flancs verticaux et également par le fait que ni ces flancs verticaux ni le substrat 2 ne sont oxydés, du fait que l'oxydation de la couche 15 est une oxydation sélective.

Nous utilisons, dans l'exemple préférentiel décrit, la propriété que possèdent les alliages à forte teneur en aluminium de s'oxyder sélectivement par rapport aux autres matériaux.

Plus généralement, tout matériau pouvant être déposé par épitaxie sur la première structure épitaxiée 10 puis être transformé sélectivement en un matériau apte à servir de masque pour épitaxie localisée peut être utilisé à la place de l'alliage à forte teneur en aluminium.

Tout matériau pouvant s'oxyder sélectivement par rapport aux autres en donnant un oxyde stable et possédant les propriétés nécessaires pour constituer un masque pour l'épitaxie localisée, peut être utilisé.

De même, on peut utiliser tout autre procédé d'oxydation pouvant permettre une oxydation sélective formant un oxyde stable et possédant les propriétés nécessaires pour l'épitaxie localisée.

On peut ainsi envisager un procédé de transformation en masque qui soit autre que l'oxydation. Par exemple, on peut envisager une nitruration sélective, s'il est possible de nitrurer un matériau sélectivement par rapport aux autres. Dans ce cas, le masque pour l'épitaxie localisée formé ne serait plus un oxyde mais un nitrure.

Une fois la deuxième structure 20 épitaxiée, le masque 15 est enlevé par gravure chimique. Dans une variante de l'invention, le masque 15 peut être enlevé par une gravure RIE d'un type choisi pour ne pas attaquer le semi-conducteur. L'homme de l'art connaît de telles gravures. Dans le cas précis du présent exemple de réalisation, il est plus simple d'enlever le masque 15 par gravure chimique.

On utilise ici la propriété d'un masque d'oxyde à pouvoir être facilement retiré par gravure chimique, sans endommager les structures sur lesquelles il est déposé.

Ainsi, on a utilisé une double propriété de l'alliage contenant de l'aluminium, qui est de résister à une gravure chimique lorsqu'il n'est pas oxydé, et d'être facilement retiré par gravure chimique ou par gravure ionique réactive lorsqu'il est oxydé.

On utilise la première propriété de résistance à la gravure pour enlever sélectivement le masque primaire 1, et on utilise la deuxième propriété de faible résistance à la gravure chimique pour enlever à son tour, sélectivement, le masque 15.

Grâce à la succession d'étapes particulière de l'invention, les différents masques sont tous déposés par épitaxie sélective et enlevés par gravure chimique, ces deux techniques étant inoffensives pour les autres structures du composant. On peut grâce à cette succession d'étapes réaliser une intégration de composants sans faire appel à une technique qui soit dommageable à une quelconque partie du composant, telle que par exemple une gravure directe du substrat, par exemple une gravure RIE non sélective ou une gravure chimique de nature à réagir sur des semi-conducteurs.

La technologie décrite précédemment a été élaborée pour les semi-conducteurs III-V. Le même principe peut aussi être appliqué pour la technologie du Silicium ou pour les semi-conducteurs II-VI.

L'invention a été décrite dans une variante élémentaire de l'invention où seulement deux types de matériaux semi-conducteurs ont été épitaxiés côte-à-côte.

L'invention prévoit également l'intégration d'un nombre plus élevé de composants sur un même substrat de base.

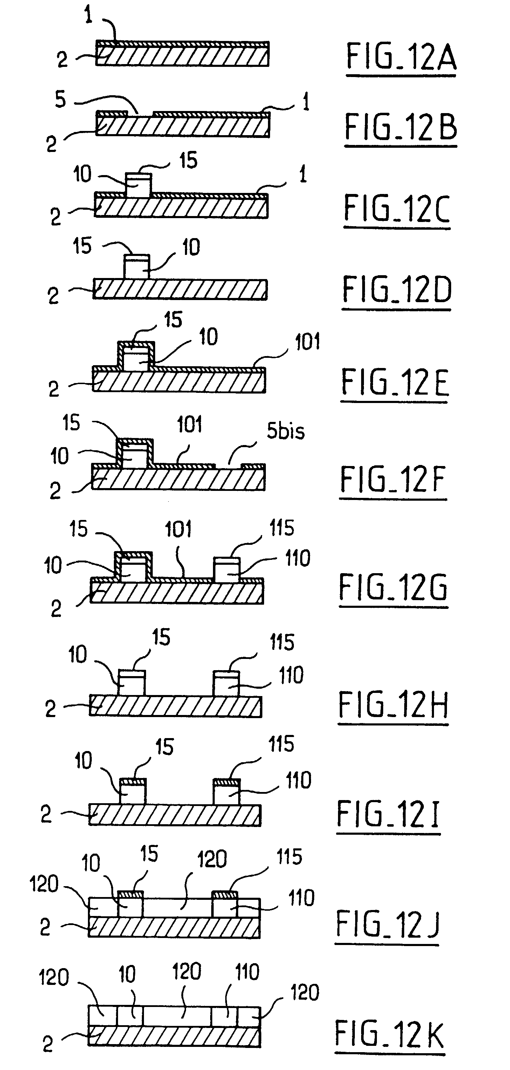

On a ainsi représenté, sur les figures 12A à 12K, un enchaînement d'étapes permettant d'intégrer trois structures de semi-conducteurs côte-à-côte, référencées 10, 110 et 120. Sur cette figure, les éléments similaires à ceux des figures 4 à 10 portent les mêmes références.

Dans un premier temps, une croissance localisée de la structure 10 et d'une couche 15 d'un alliage à forte teneur en aluminium est réalisée (figures 12A à 12D) en reprenant les étapes décrites précédemment et représentées aux figures 4 à 7.

La structure est ensuite recouverte dans son ensemble d'une couche de nitrure 101 (figure 12E), identique à celle appliquée à la première étape (figure 12A) sur le substrat 2, et par une technique identique. On réalise par gravure RIE au moins une zone de croissance 5bis par gravure dans le masque 101 (figure 12F), sur laquelle on réalise une croissance localisée de la deuxième structure de semi-conducteur 110, recouverte d'une fine couche 115 d'alliage à forte teneur en aluminium (figure 12G). Le masque 101 est ensuite enlevé (figure 12H), les couches 15 et 115 sont oxydées sélectivement (figure 12I), et sont utilisées comme masques pour une épitaxie sélective d'une troisième structure 120 de semi-conducteur (figure 12J). La troisième structure 120 couvre donc l'ensemble de la surface du substrat 2 non occupé par les structures 10 et 110.

Les masques d'oxyde 15 et 115 sont ensuite retirés (figure 12K) par gravure chimique.

On obtient alors trois structures à semi-conducteur 10, 110 et 120 intégrées sur un substrat non gravé 2, et parfaitement auto-alignées.

De manière plus générale, on peut réaliser ainsi un grand nombre n de structures à semi-conducteur recouvertes d'une couche d'alliage à forte teneur en aluminium, et non accolées.

Pour cela, avant chaque croissance localisée, numérotée n, on dépose par exemple un masque de nitrure sur l'ensemble des structures numérotées de 1 à (n - 1) déjà réalisées sur le substrat et comportant une couche supérieure d'alliage, puis on réalise dans le masque une zone de croissance localisée choisie, par gravure, qui est non adjacente aux structures existantes. Après croissance localisée par épitaxie de la structure n à semi-conducteur dans cette zone choisie, et de sa couche d'alliage supérieure, le masque de nitrure est enlevé.

Dans une étape finale, après retrait des couches de nitrure, on oxyde l'ensemble des couches d'alliage et on réalise une croissance localisée d'une dernière structure à semi-conducteur, complémentaire, aux endroits non occupés par les structures 1 à n et protégées par leur masque d'oxyde.

Cette dernière structure est auto-alignée avec chacune des structures 1 à n. On enlève enfin les masques d'oxyde.

L'invention s'étend à un composant obtenu par la mise en oeuvre d'un procédé conforme à l'esprit des procédés décrits ci-dessus.

Les performances des différents types de composants sont améliorées par le fait qu'ils ne comportent pas de défauts engendrés par une éventuelle gravure du substrat.

On comprend également que l'invention permet de tirer parti, en micro et en opto-électronique, d'un auto-alignement parfait et aisément mis en oeuvre.

Bien sûr, l'invention n'est pas limitée aux exemples de réalisation qui viennent d'être décrits, mais s'étend à toute variante conforme à son esprit.

En particulier, on peut remplacer la couche d'alliage d'aluminium par une couche de tout matériau comportant la double propriété de résister dans un premier état à une gravure de retrait d'un masque primaire et de constituer dans un deuxième état un masque pour épitaxie localisée. Un tel matériau peut ne pas contenir d'aluminium.

Cette double propriété sera, grâce à la succession des étapes du procédé selon l'invention, mise à profit pour obtenir un masque pour épitaxie parfaitement aligné sur une structure qui est entourée par un substrat non altéré.
[1] "Monolithic integration of multiple quantum well DFB laser and electroabsorption modulators", A. Ramdane, A. Ougazzaden, Ph. Krauz, Microelectronics Journal 25 (1994) 691.
[2] "Molecular Beam Epitaxy of AlGaInAs on patterned substrates for optoelectronic applications", J.P. Praseuth, Microelectronic applications 1995.
[3] "Epitaxie localisée par jets chimiques sur substrats GaAs et InP", Ph. Legay, thèse présentée à l'Université de Nantes (1995).
[4] Dallesasse J.M., Holonyack N., Sugg A.R., Richard T.A., El-Zein N. "Hydrolysation oxidation of AlxGal-xAs-AlAs-GaAs quantum well heterostructures and superlattices", *Appl. Phys. Lett. 57, (1990) 2844.*
[5] Journal of Cristal Growth, 124, 1992, p.186, H. Heinecke, B.Baur, A.Mirklis, R.Matz, C.Cremer, R.Höger.

## Revendications

1. Procédé d'intégration de plusieurs structures à semi-conducteur (10, 20, 110, 120) sur un même substrat (2), caractérisé en ce qu'on réalise :
a) un dépôt d'un masque primaire (1) sur ledit substrat (2),
b) des ouvertures dans ce masque primaire (1) découvrant des zones choisies (5) de la surface du substrat (2),
c) une épitaxie d'une structure A de composant semi-conducteur localisée dans lesdites zones choisies (5) du substrat (2), terminée par
d) une épitaxie d'un matériau B (15) localisée sur la structure A (10), le matériau B (15) étant apte à être transformé sélectivement en un matériau C pouvant constituer un masque (15) pour épitaxie localisée,
e) un retrait dudit masque primaire (1),
f) une transformation sélective dudit matériau B en ledit matériau C de sorte que le matériau C constitue un autre masque (15) pour épitaxie localisée, et
g) une épitaxie d'une structure D (20) de composant semi-conducteur localisée à l'extérieur dudit autre masque (15).

2. Procédé d'intégration selon la revendication 1, caractérisé en ce que l'on réalise les étapes a, b, c, d, e de la revendication 1, puis on réalise au moins une fois l'enchaînement des étapes suivantes :
e1) on réalise un dépôt d'un nouveau masque primaire (101) sur l'ensemble formé par le substrat (2), et les différentes structures épitaxiées (10) sur ce substrat (2),
e2) on réalise des ouvertures (5bis) dans ce nouveau masque primaire (101), découvrant des nouvelles zones choisies (5bis) de la surface du substrat (2),
e3) on réalise une épitaxie d'une structure de composant semi-conducteur A2 (110) localisée dans lesdites nouvelles zones choisies (5bis) du substrat (2), terminée par
e4) une épitaxie du matériau B (115) localisée sur la structure A2 (10),
e5) on retire ledit nouveau masque primaire (101),
et en ce qu'on procède ensuite à une phase finale consistant à réaliser :
f1) une transformation sélective dudit matériau B (15, 115) en ledit matériau C de sorte que le matériau C constitue au moins un dit autre masque (15, 115) pour épitaxie localisée,
f2) une épitaxie d'une structure de composant semi-conducteur D (120) localisée à l'extérieur du ou des autre(s) masque(s) (15, 115).

3. Procédé d'intégration selon la revendication 1 ou 2, caractérisé en ce que l'on réalise également, après l'épitaxie localisée à l'extérieur du ou des autre (s) masques, un retrait du ou desdits autre(s) masque(s) (15, 115).

4. Procédé d'intégration selon l'une quelconque des revendications 1, 2, ou 3, caractérisé en ce que ledit matériau B (15, 115) est un alliage à forte teneur en aluminium et en ce que les étapes f et/ou f1 consistent à réaliser une oxydation sélective de cet alliage.

5. Procédé d'intégration selon la revendication 4, caractérisé en ce que ladite oxydation sélective est réalisée à une température comprise entre 300°C et 540°C sous flux d'azote saturé en eau.

6. Procédé d'intégration selon l'une quelconque des revendications précédentes, caractérisé en ce que le matériau B (15,115) est un alliage de concentration en aluminium parmi les éléments III qui est supérieure à 80%.

7. Procédé d'intégration selon l'une quelconque des revendications précédentes, caractérisé en ce que le matériau B (15, 115) est un alliage de formule Alₓ Ga₁₋ₓ As où x est supérieur à 0,80.

8. Procédé d'intégration selon l'une quelconque des revendications 1 à 5, caractérisé en ce que le matériau B (15, 115) est un alliage de formule AlAs.

9. Procédé d'intégration selon l'une quelconque des revendications 1 à 5, caractérisé en ce que le matériau B (15, 115) est un alliage de formule AlInAs.

10. Procédé d'intégration selon l'une quelconque des revendications 1 à 5, caractérisé en ce que le matériau B (15, 115) est un alliage de formule AlAsSb.

11. Procédé d'intégration selon l'une quelconque des revendications 4 à 10, caractérisé en ce que ledit matériau B est déposé sur la structure A (10) selon une couche (15, 115) ayant une épaisseur comprise entre 10 et 150 nanomètres.

12. Procédé d'intégration selon l'une quelconque des revendications 1 à 11, caractérisé en ce que les structures A et D sont réalisées à partir de matériaux semi-conducteurs III-V.

13. Procédé d'intégration selon l'une quelconque des revendications 1 à 12, caractérisé en ce que les structures A et D sont réalisées à partir de matériaux semi-conducteurs II-VI.

14. Procédé d'intégration selon l'une quelconque des revendications 1 à 13, caractérisé en ce que les structures A et D sont réalisées à partir de matériaux basés sur la technologie du silicium.

15. Procédé d'intégration selon l'une quelconque des revendications précédentes, caractérisé en ce que lesdits masques primaires (1) sont des masques de nitrure déposés par la technique CVD (Chemical Vapor Deposition).

16. Procédé d'intégration selon l'une quelconque des revendications précédentes, caractérisé en ce que lesdites ouvertures (5, 5bis) dans lesdits masques primaires (1) sont réalisées par Gravure Ionique Réactive.

17. Procédé d'intégration selon l'une quelconque des revendications précédentes, caractérisé en ce que l'épitaxie de la structure A et/ou de la structure A2 est de nature à former une structure (10) à flancs verticaux.

18. Procédé d'intégration selon l'une quelconque des revendications précédentes, caractérisé en ce que au moins une épitaxie localisée est réalisée par jets chimiques.

19. Procédé d'intégration selon l'une quelconque des revendications précédentes, caractérisé en ce que lesdits retraits des masques (1, 15, 115) sont effectués par gravure chimique.

20. Composant obtenu par la mise en oeuvre du procédé conforme à l'une quelconque des revendications 1 à 19.
